(19) Europäisches Patentamt
European Patent Office
Office européen des brevets

(11) **EP 4 224 255 A1**

(12) **EUROPEAN PATENT APPLICATION**

(43) Date of publication:
**09.08.2023 Bulletin 2023/32**

(51) International Patent Classification (IPC):
**G03F 7/20** (2006.01)

(21) Application number: **22155715.0**

(52) Cooperative Patent Classification (CPC):
**G03F 7/70633**

(22) Date of filing: **08.02.2022**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventors:
• **NAGHIBZADEH, Shahrzad
5500AH Veldhoven (NL)**
• **JAVAHERI, Narjes
5500AH Veldhoven (NL)**

(74) Representative: **ASML Netherlands B.V.
Corporate Intellectual Property
P.O. Box 324
5500 AH Veldhoven (NL)**

(54) **METROLOGY METHOD**

(57) Disclosed is a method for determining a parameter of interest relating to at least one target on a substrate. The method comprises obtaining metrology data comprising at least one asymmetry signal, said at least one asymmetry signal comprising a difference or imbalance in a measurement parameter from the target; obtaining a trained model having been trained or configured to relate said at least one asymmetry signal to the parameter of interest, the trained model comprising at least one proxy for at least one nuisance component of the at least one asymmetry signal; and inferring said parameter of interest for said at least one target from said at least one asymmetry signal using the trained model.

Fig. 6

## Description

BACKGROUND

Field of the Invention

The present invention relates to a lithographic process and more specifically to a method to measure a parameter of a lithographic process.

Background Art

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, a measure of the accuracy of alignment of two layers in a device. Overlay may be described in terms of the degree of misalignment between the two layers, for example reference to a measured overlay of 1nm may describe a situation where two layers are misaligned by 1nm.

Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a "spectrum" from which a property of interest of the target can be determined. Determination of the property of interest may be performed by various techniques: e.g., reconstruction of the target by iterative approaches such as rigorous coupled wave analysis or finite element methods; library searches; and principal component analysis.

The targets used by conventional scatterometers are relatively large, e.g., $40\mu$m by $40\mu$m, gratings and the measurement beam generates a spot that is smaller than the grating (i.e., the grating is underfilled). This simplifies mathematical reconstruction of the target as it can be regarded as infinite. However, in order to reduce the size of the targets, e.g., to $10\mu$m by $10\mu$m or less, e.g., so they can be positioned in amongst product features, rather than in the scribe lane, metrology has been proposed in which the grating is made smaller than the measurement spot (i.e., the grating is overfilled). Typically such targets are measured using dark field scatterometry in which the zeroth order of diffraction (corresponding to a specular reflection) is blocked, and only higher orders processed. Examples of dark field metrology can be found in international patent applications WO 2009/078708 and WO 2009/106279 which documents are hereby incorporated by reference in their entirety. Further developments of the technique have been described in patent publications US20110027704A, US20110043791A and US20120242970A. Modifications of the apparatus to improve throughput are described in US2010201963A1 and US2011102753A1. The contents of all these applications are also incorporated herein by reference. Diffraction-based overlay using dark-field detection of the diffraction orders enables overlay measurements on smaller targets. These targets can be smaller than the illumination spot and may be surrounded by product structures on a wafer. Targets can comprise multiple gratings which can be measured in one image.

There are several methods for overlay inference. A known method of determining overlay from metrology images such as those obtained using dark-field methods, while making some correction for non-overlay asymmetry is known as the A+/A- regression method. This method comprises measuring a biased target having two differently biased sub-targets using radiation having at least two different wavelengths, and plotting intensity asymmetry from one of the sub-targets against intensity asymmetry from the other of the sub-targets for each wavelength. Regressing through each data point yields a line having a slope indicative of overlay.

It would be desirable to improve on such known overlay inference methods.

SUMMARY OF THE INVENTION

The invention in a first aspect provides a method for determining a parameter of interest relating to at least one target on a substrate. The method comprises obtaining metrology data comprising at least one asymmetry signal, said at least one asymmetry signal comprising a difference or imbalance in a measurement parameter; obtaining a trained model having been trained or configured to relate said at least one asymmetry signal to the parameter of interest, the trained model comprising at least one proxy for at least one nuisance component of the at least one asymmetry signal; and inferring said parameter of interest for said at least one target from said at least one asymmetry signal using the trained model.

The invention in a second aspect provides a method of training a model to relate asymmetry signals to a parameter of interest, the model comprising at least one proxy for at least one nuisance component of the asymmetry signals, the method comprising: obtaining training data comprising a plurality of training asymmetry signals relating to a plurality of training targets; and training said model by optimizing a respective training parameter for each of said at least one proxy.

The invention in a third aspect provides a metrology apparatus being operable to perform the method of the first or second aspect.

In a further aspect of the invention, there is provided a computer program comprising program instructions operable to perform the method of the first aspect when run on a suitable apparatus.

Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS

Embodiments of the invention will now be described, by way of example only, with reference to the accompanying drawings in which:

Figure 1 depicts a lithographic apparatus according to an embodiment of the invention;
Figure 2 depicts a lithographic cell or cluster according to an embodiment of the invention;
Figure 3 comprises (a) a schematic diagram of a dark field scatterometer for use in measuring targets using a first pair of illumination apertures, (b) a detail of diffraction spectrum of a target grating for a given direction of illumination (c) a second pair of illumination apertures providing further illumination modes in using the scatterometer for (micro) diffraction based overlay (DBO or μDBO) measurements and (d) a third pair of illumination apertures combining the first and second pair of apertures;
Figure 4 depicts a known form of multiple grating target and an outline of a measurement spot on a substrate;
Figure 5 depicts an image of the target of Figure 4 obtained in the scatterometer of Figure 3;
Figure 6 is a flow diagram of (a) a training or calibration phase and (b) a production or inference phase of a first embodiment of the invention; and
Figure 7 is a flow diagram of (a) a training or calibration phase and (b) a production or inference phase of a first embodiment of the invention.

DETAILED DESCRIPTION OF EXEMPLARY EMBODIMENTS

Before describing embodiments of the invention in detail, it is instructive to present an example environment in which embodiments of the present invention may be implemented.

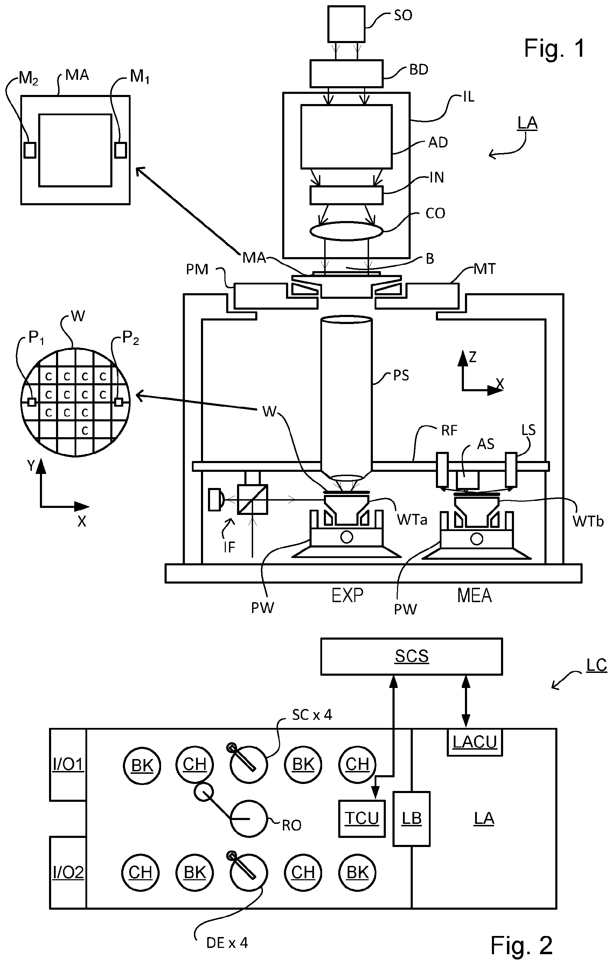

Figure 1 schematically depicts a lithographic apparatus LA. The apparatus includes an illumination optical system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; a substrate table (e.g., a wafer table) WT constructed to hold a substrate (e.g., a resist coated wafer) W and connected to a second positioner PW configured to accurately position the substrate in accordance with certain parameters; and a projection optical system (e.g., a refractive projection lens system) PS configured to project a pattern imparted to the radiation beam B by patterning device MA onto a target portion C (e.g., including one or more dies) of the substrate W.

The illumination optical system may include various types of optical or non-optical components, such as refractive, reflective, magnetic, electromagnetic, electrostatic or other types of components, or any combination thereof, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support may be a frame or a table, for example, which may be fixed or movable as required. The patterning device support may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

As here depicted, the apparatus is of a transmissive type (e.g., employing a transmissive mask). Alternatively, the apparatus may be of a reflective type (e.g., employing a programmable mirror array of a type as referred to above, or employing a reflective mask).

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD for adjusting the angular intensity distribution of the radiation beam. Generally, at least the outer and/or inner radial extent (commonly referred to as $\sigma$-outer and $\alpha$-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross section.

The radiation beam B is incident on the patterning device (e.g., mask) MA, which is held on the patterning device support (e.g., mask table MT), and is patterned by the patterning device. Having traversed the patterning device (e.g., mask) MA, the radiation beam B passes through the projection optical system PS, which focuses the beam onto a target portion C of the substrate W, thereby projecting an image of the pattern on the target portion C. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment markers may also be included within dies, in amongst the device features, in which case it is desirable that the markers be as small as possible and not require any different imaging or process conditions than adjacent features. The alignment system, which detects the alignment markers is described further below.

Lithographic apparatus LA in this example is of a so-called dual stage type which has two substrate tables WTa, WTb and two stations - an exposure station and a measurement station - between which the substrate tables can be exchanged. While one substrate on one substrate table is being exposed at the exposure station, another substrate can be loaded onto the other substrate table at the measurement station and various preparatory steps carried out. The preparatory steps may include mapping the surface control of the substrate using a level sensor LS and measuring the position of alignment markers on the substrate using an alignment sensor AS. This enables a substantial increase in the throughput of the apparatus.

The depicted apparatus can be used in a variety of modes, including for example a step mode or a scan mode. The construction and operation of lithographic apparatus is well known to those skilled in the art and need not be described further for an understanding of the present invention.

As shown in Figure 2, the lithographic apparatus LA forms part of a lithographic system, referred to as a lithographic cell LC or a lithocell or cluster. The lithographic cell LC may also include apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

In order that the substrates that are exposed by the lithographic apparatus are exposed correctly and consistently, it is desirable to inspect exposed substrates to measure properties such as overlay between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates, especially if the inspection can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatuses have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

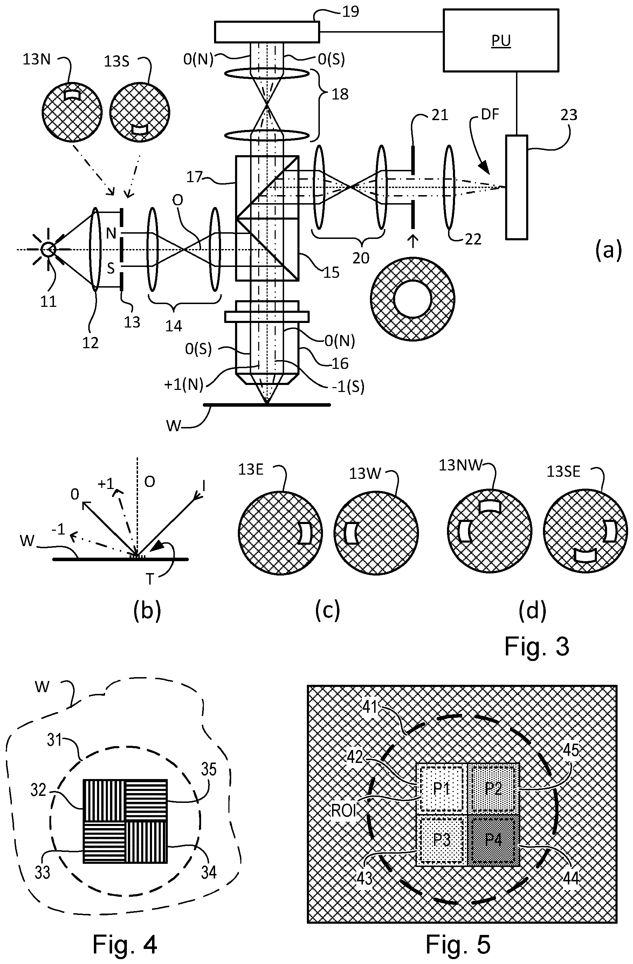

A metrology apparatus is shown in Figure 3(a). A target T and diffracted rays of measurement radiation used to illuminate the target are illustrated in more detail in Figure 3(b). The metrology apparatus illustrated is of a type known as a dark field metrology apparatus. The metrology apparatus depicted here is purely exemplary, to provide an explanation of dark field metrology. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 3(b), target T is placed with substrate W normal to the optical axis O of objective lens 16.

The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 3(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 3(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 3 are purely examples. In another embodiment of the invention, on-axis illumination of the targets is used and an aperture stop with an off-axis aperture is used to pass substantially only one first order of diffracted light to the sensor. In other examples, a two quadrant aperture may be used. This may enable simultaneous detection of plus and minus orders, as described in US2010201963A1, mentioned above. Embodiments with optical wedges (segmented prisms or other suitable elements) in the detection branch can be used to separate the orders for imaging spatially in a single image, as described in US2011102753A1, mentioned above. In yet other embodiments, 2nd, 3rd and higher order beams (not shown in Figure 3) can be used in measurements, instead of or in addition to the first order beams. In yet other embodiments, a segmented prism can be used in place of aperture stop 21, enabling both +1 and -1 orders to be captured simultaneously at spatially separate locations on image sensor 23.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 3(c) and (d). The use of these, and numerous other variations and applications of the apparatus are described in prior published applications, mentioned above.

Figure 4 depicts an overlay target or composite overlay target formed on a substrate according to known practice. The overlay target in this example comprises four sub-targets (e.g., gratings) 32 to 35 positioned closely together so that they will all be within a measurement spot 31 formed by the metrology radiation illumination beam of the metrology apparatus. The four overlay sub-targets thus are all simultaneously illuminated and simultaneously imaged on sensor 23. In an example dedicated to measurement of overlay, sub-targets 32 to 35 are themselves composite structures formed by overlying gratings that are patterned in different layers of the semiconductor device formed on substrate W. Sub-targets 32 to 35 may have differently biased overlay offsets in order to facilitate measurement of overlay between the layers in which the different parts of the composite sub-targets are formed. Sub-targets 32 to 35 may also differ in their orientation, as shown, so as to diffract incoming radiation in X and Y directions. In one example, sub-targets 32 and 34 are X-direction sub-targets with two different biases (e.g., biases of the +d, -d, respectively). Sub-targets 33 and 35 are Y-direction sub-targets with two different biases (e.g., offsets +d and -d respectively). Separate images of these sub-targets can be identified in the image captured by sensor 23. This is only one example of an overlay target. An overlay target may comprise more or fewer than two sub-targets per direction.

Figure 5 shows an example of an image that may be formed on and detected by the sensor 23, using the overlay target of Figure 4 in the apparatus of Figure 3, using the aperture plates 13NW or 13SE from Figure 3(d). While the pupil plane image sensor 19 cannot resolve the different individual sub-targets 32 to 35, the image sensor 23 can do so. The hatched area 40 represents the field of the image on the sensor, within which the illuminated spot 31 on the substrate is imaged into a corresponding circular area 41. Within this, rectangular areas 42-45 represent the images of the small overlay target sub-targets 32 to 35. If the overlay targets are located in product areas, product features may also be visible in the periphery of this image field. Image processor and controller PU processes these images using pattern recognition to identify the separate images 42 to 45 of sub-targets 32 to 35. In this way, the images do not have to be aligned very precisely at a specific location within the sensor frame, which greatly improves throughput of the measuring apparatus as a whole.

Once the separate images of the overlay targets have been identified, the intensities of those individual images can be measured, e.g., by averaging or summing selected pixel intensity values within the identified areas. Intensities and/or other properties of the images can be compared with one another. These results can be combined to measure different parameters of the lithographic process. Overlay performance is an important example of such a parameter.

Using for example the method described in applications such as US20110027704A, mentioned above, overlay (i.e., undesired and unintentional overlay misalignment) between the two layers within the sub-targets 32 to 35 is measured. Such a method may be referred to as micro diffraction based overlay (μDBO). This measurement may be done through overlay target asymmetry, as revealed by comparing their intensities in the +1 order and -1 order dark field images (the intensities of other complementary higher orders can be compared, e.g. +2 and -2 orders) to obtain a measure of the intensity asymmetry.

There are several methods for overlay inference from such measurements, which aim to separate or isolate the wanted overlay signal from other nuisance contributions (e.g., *inter alia* non-overlay target asymmetries). These methods differ may data dimensions used in the model, the model itself, and/or the model/recipe setup. A number of methods have been developed which use a multi wavelength data dimension. Other methods use additional data dimensions, such as multi target positions, so as to acquire more information in a diversified input. These methods may also require a condition for model/recipe setup, such as external reference data.

Present overlay inference methods, and in particular after-development inspection ADI (i.e., pre-etch inspection) overlay inference methods (e.g., compatible with faster metrology techniques such as dark-field metrology), suffer from a number of drawbacks which include:

- A lack of overlay estimation model flexibility with respect to process variations in the production process.
- A lack of accuracy and robustness of the estimated overlay to (e.g., symmetric and asymmetric) process variations.
- Inefficient use of the existing signal dimensions in the data which provides the potential for more accurate overlay estimation.

In understanding the concepts disclosed herein, it should be appreciated that the measured asymmetry signal A is a function of overlay and any process variations:

$$A = f(OV, PA, PS) \cong \frac{\partial A}{\partial OV} OV + \sum_i \frac{\partial A}{\partial PA_i} PA_i + \sum_j \frac{\partial A}{\partial PS_j} PS_j$$

where $A$ is the measured asymmetry signal, $OV$ is the unknown true overlay (the parameter of interest), $PA$ is the asymmetric process variation and $PS$ describes the symmetric process variation. These are geometrical properties: independent of wavelength and polarization and usually depend on target position $i$ on the wafer and pixel position $j$ in the captured image (or region of interest ROI). $\frac{\partial A}{\partial OV}$, $\frac{\partial A}{\partial PA_i}$, $\frac{\partial A}{\partial PS_j}$ describe the sensitivity of the measured asymmetry to each of these unknown parameters and are dependent on wavelength and polarization. As such, the first term describes the overlay signal component, the second term describes the asymmetric non-overlay signal contribution (a first nuisance component) and the third term describes the symmetric non-overlay signal component (a second nuisance component).

Examples of asymmetric process variations include *inter alia*: a difference in sidewall angle dSWA (e.g., between two walls of a grating feature), a (non-overlay) grating asymmetry, a floor tilt. Examples of symmetric process variations include *inter alia*: layer thickness variation, CD variation, grating imbalance GI and symmetric SWA variation.

An intensity image can be decomposed as:

$$I = S + A$$

where S is the symmetrical part and A the asymmetrical part. The asymmetrical part comprises the overlay information. For an infinite grating pair, $A(ov)$ is periodic with pitch $P$ and therefore $A(ov)$ can be written as:

$$A(ov) = \sum_{i=1}^{\infty} K_i \sin \frac{2\pi i}{P} ov \approx K_1 \sin \frac{2\pi}{P} ov + K_2 \sin \frac{4\pi}{P} ov + K_3 \sin \frac{6\pi}{P} ov + \cdots.$$

Using the atan approximation, only the first term of the above expression may be taken without expanding sin(x):

$$A(ov) \approx K_1 \sin \frac{2\pi}{P} ov$$

In this formulation, $K$ is a measure of sensitivity (Jacobian) of the asymmetric part of the intensity to the overlay.
The measured asymmetry signal may be, for example, an intensity asymmetry of complementary diffraction orders or phase difference asymmetry from a pair of complementary sub-targets ("M pad" and "W pad"), depending on whether the metrology method is intensity based (e.g., $\mu$DBO) or phase based (e.g., continuous DBO or cDBO). As such, for intensity based applications, A may be defined as $A_+ = I_{+b}^{+1} - I_{+b}^{-1}$ and $A_- = I_{-b}^{+1} - I_{-b}^{-1}$ (conveniently written as $A_\pm = (I_{+1} - I_{-1})_{\pm b}$), where $I_{+1}, I_{+1}$ are the respective intensities of the +1 diffraction order and -1 diffraction order from each sub-target having respective biases *+b, -b.*
For phase based applications asymmetry signal A may be defined as the phase difference between a diffraction order from an "M pad" and a corresponding diffraction order from a "W pad", optionally averaged over both diffraction orders of a complementary diffraction order pair: e.g., $A = (\phi_M - \phi_W)_{+1} + (\phi_M - \phi_W)_{-1}$, where $(\phi_M - \phi_W)_{+1}$, $(\phi_M - \phi_W)_{-1}$ are the measured phase difference between the "M pad" and "W pad" of the +1 diffraction order and -1 diffraction order respectively. As such, it can be appreciated that the concepts described herein are applicable to different types of asymmetry signal. The principle of cDBO is described in Matsunobu et al, Novel diffraction-based overlay metrology utilizing phase-based overlay for improved robustness, Proc. SPIE 11611, Metrology, Inspection, and Process Control for Semiconductor Manufacturing XXXV, 1161126 (22 February 2021), which is incorporated herein by reference.
Like a $\mu$DBO target, a cDBO target comprises multiple pads or sub-targets (optionally per direction), each sub-target having overlaid gratings in respective layers for which an overlay value is to be measured. Instead of the gratings having the same pitch in the two layers like a $\mu$DBO target, cDBO targets comprise sub-targets each having gratings of different pitches in the two layers. More specifically a typical cDBO target comprises an arrangement of two different types of sub-targets (e.g., per direction): an "M pad" or "M sub-grating" which comprises a bottom grating having a smaller pitch than a top grating, with a "W pad" or "W sub-grating" which has these gratings reversed (i.e., it has the same pitches as the M pad but with the larger pitch in the top layer).
Different example arrangements of cDBO targets are described in PCT application WO2021224009A1, which is incorporated herein by reference. The cDBO targets may comprise at least one pair of similar target regions which are arranged such that the whole target arrangement is, or at least the target regions for measurement in a single direction together are, centrosymmetric (i.e., the arrangement is the same if rotated through 180 degrees). Such an arrangement can help address matching issues caused by distortions in the metrology tool optics. Generally, for inferring overlay in cDBO, a target arrangement comprises two (or more) clusters of sub-targets, each cluster comprising at least one M pad and one W pad per direction (a pad may be shared between clusters in some designs). As such, each cluster can be used independently to infer overlay. However, to address the matching issues, overlay may be determined as an average of the overlay computed per each cluster:

$$ov_{c_i} = \frac{p_1 * p_2}{2\pi * (p_1 + p_2)} * \text{mod}_{2\pi}\left(\phi_{M,c_i}^{+1} - \phi_{W,c_i}^{+1} + \phi_{M,c_i}^{-1} - \phi_{W,c_i}^{-1}\right)$$

$$ov = \frac{ov_{c1} + ov_{c2}}{2}$$

where $c_i$ is the ith cluster, $p_1$ and $p_2$ are the grating pitches of the gratings in each layer.

The measured symmetry signal, in an intensity-based application, can be determined as the sum of the intensity measured from the normal and complementary branches, i.e., $S_{\pm b} = (I^{+1} + I^{-1})_{\pm b}$. In a phase-based application such as cDBO metrology, the phase symmetry cannot be directly measured without a phase reference. However, the amplitude is measured independently from the phase in cDBO metrology and therefore can be accessed directly. As such, for cDBO applications, the symmetry signal may be defined as: $S_{M,W} = (a^{+1} + a^{-1})_{M,W}$. where $a$ is the amplitude signal (difference between the max and min intensity from each pad (M,W)).

As such, symmetric and asymmetric process variations each induce a respective component in the measured signal. To achieve accurate and robust overlay inference, the sensitivity of the measured signal to process variations should be suppressed. However, information from only a single measurement cannot separate overlay from the other nuisance contributors described by PA and PS. Also, process variations are highly stack and application dependent. Therefore, a more flexible model is desirable.

Described herein is an improved overlay inference method (e.g., for ADI overlay) which increases the accuracy and robustness of the inference to both symmetric and asymmetric process variations. One aspect of the proposal comprises a multi-dimensional regression, which uses the diversity in multiple information channels: e.g., intensity channels, for example relating to some or all of: positive bias/W pad, negative bias/M pad, normal diffraction order, complementary diffraction order, different pixels inside the ROI, the measurement wavelengths, target positions on the wafer. This results in the most efficient use of the diversity present in the information channels of presently performed measurement strategies and does not require additional metrology compared to present (e.g., μDBO/cDBO) methods.

Alternatively or in addition, another aspect of the proposed method is the use of a parameterized model which comprises at least a symmetric proxy for at least the symmetric process variations, and optionally separate symmetric and asymmetric proxies for the symmetric process variations and asymmetric process variations respectively. This helps make the overlay inference model more flexible. Additionally, the inference method may be data driven or training based; the model parameters may be trained or calibrated based on available external reference data; or in a self-referenced embodiment, on the known target biases (e.g., for μDBO applications). For a cDBO self-referenced embodiment, the model parameters may be trained or calibrated on the equality of inference from pairs of sub-target clusters.

As such, a method is described for determining a parameter of interest such as overlay, the method comprising: obtaining asymmetry signals (e.g., captured at an image plane such as intensity asymmetry and/or phase difference asymmetry signals); obtaining a trained model having been trained to relate said metrology signals to the parameter of interest in terms of at least one proxy for at least one nuisance component; and using the trained model to infer said parameter of interest from said metrology signals.

In an embodiment, the trained model has been trained to relate said asymmetry signals to the parameter of interest in terms of at least two proxies, an asymmetric first proxy for an asymmetric nuisance component and a symmetric proxy for a symmetric nuisance component. The trained model may be a multi-dimensional regression model.

For an intensity based embodiment, such as μDBO, the method may comprise measuring the intensity asymmetry of complementary diffraction orders from each biased sub-target, an intensity summation for the symmetric proxy and a second-order intensity asymmetry for the asymmetric proxy. In the cDBO application, the phase difference between M and W pads (e.g., averaged over a pair of complementary diffraction orders), amplitude symmetry and at least one amplitude asymmetry may be measured.

Also disclosed is a method of training said model to relate asymmetry signals to a parameter of interest in terms of at least one proxy for at least one nuisance component (an optionally at least an asymmetric first proxy for an asymmetric nuisance component and a symmetric proxy for a symmetric nuisance component). In a further embodiment, more than one asymmetric proxies may be defined. The training may use external training data (reference values for the parameter of interest), or it may be self-referenced by training on known properties of the target designs (e.g., target biases for μDBO and target clusters for centrosymmetric cDBO targets).

Such a method exploits the variation in the available information channels in the measurement data (e.g., obtained from the dark-field images). There are multiple information channels (data dimensions) in the measured dark-field images obtained via, for example, μDBO or cDBO metrology. Using this diversity, the proposed methods aim to separate the real overlay signal from the nuisance component(s). Furthermore, the proposed methods aim to suppress the sensitivity to nuisance (e.g., symmetric and asymmetric) process variations by combining multiple information channels e.g., intensity or phase (optionally per pixel or image region), wavelengths and target locations. To incorporate the additional dimensions efficiently and effectively, the overlay estimation problem may be formulated as a multi-dimensional regression problem.

To suppress the effect of process variations, it is proposed to learn the sensitivity and magnitude of process variations in a data driven method. This may be achieved by parameterizing the overlay inference model with sensitivities to process variations. The exact value and types of the symmetric and asymmetric process variations are unknown and direct measurement is either impossible or impractical. For this reason, it is proposed in an embodiment to define a symmetrical proxy **P** and at least one asymmetrical proxy **G** for these variations, based on the measured data. If training targets are used which have a programmed or known overlay (or a derived overlay parameter $v_\pm$) training parameters **M** and **N** relating to the proxies on the training targets can be calibrated or trained and apply the learnt model on production targets. As such, in an externally referenced intensity based ($\mu$DBO) embodiment (i.e., where known reference overlay values are available to label the training data), the model may take form, for the positive biased and negative biased target pads (sub-targets) +b and -b:

$$v_{+b,i} = \left(\left[1\ P_{+b,i}\right]M_{+b} + \left[1\ G_i^{\mathrm{T}}\right]N_{+b}\right)\Delta I_{+b,i}$$

$$v_{-b,i} = \left(\left[1\ P_{-b,i}\right]M_{-b} + \left[1\ G_i^{\mathrm{T}}\right]N_{-b}\right)\Delta I_{-b,i}$$

which may be represented more conveniently as:

$$v_{\pm\mathrm{b},i} = \left(\left[1\ P_{\pm b,i}\right]M_{\pm b} + \left[1\ G_i^{\mathrm{T}}\right]N_{\pm b}\right)\Delta I_{\pm b,i} \qquad (1)$$

The overlay parameter $v_{\pm\mathrm{b},i}$ may, for example, take one of the following forms depending on whether a sine or linear overlay transform is used:

$$\begin{cases} v_{+\mathrm{b}} := \sin\left(\frac{2\pi}{P}\left(ov + b\right)\right) \\ v_{-\mathrm{b}} := \sin\left(\frac{2\pi}{P}\left(ov - b\right)\right) \end{cases} \mathrm{or} \begin{cases} v_{+b} := ov + b \\ v_{-b} := ov - b \end{cases}$$

where *ov* is the true overlay. Note that bold-face lower case letters denote vectors, bold-face upper case letters denote matrices and normal letters denote scalars.

Training or calibration of the model comprises performing the following minimization for training parameters $M_{\pm b}$ and $N_{\pm b}$:

$$\underset{\begin{bmatrix} M_{\pm b} \\ N_{\pm b} \end{bmatrix}}{Minimize}\ \left\| v_{\pm b} - \mathrm{vect}\left(\mathrm{diag}\left(\left[1\ P_{\pm b}{}^T 1\ G^T\right]\begin{bmatrix} M_{\pm b} \\ N_{\pm b} \end{bmatrix}\Delta I_{\pm b}\right)\right)\right\|^2$$

where: $v_\pm \in \mathbb{R}^{N_t \times 1}$, $\Delta I_{\pm b} \in \mathbb{R}^{N_p N_\lambda \times N_t}$ are the measured intensity asymmetries, $P_{\pm b} \in \mathbb{R}^{N_p N_\lambda \times N_t}$ is a symmetric proxy for symmetric process variations, $G \in \mathbb{R}^{N_p N_\lambda \times N_t}$ is an asymmetric proxy for asymmetric process variations. Training parameters have the dimensions $M_{\pm b}, N_{\pm b} \in \mathbb{R}^{(N_p N_\lambda + 1) \times (N_p N_\lambda)}$. $N_\lambda$ is the number of measurement wavelengths, $N_t$ is the number of target positions and $N_p$ is the number of pixels (which can be treated as a single pixel if a single intensity value per sub-target is used, e.g., averaged over an ROI, as is presently done in $\mu$DBO/cDBO). This can be represented conveniently as:

$$\underset{\begin{bmatrix} M_{\pm b} \\ N_{\pm b} \end{bmatrix}}{Minimize}\ \left\| v_{\pm b} - H_{\pm b}\mathrm{vec}\left(\begin{bmatrix} M_{\pm b} \\ N_{\pm b} \end{bmatrix}\right)\right\|^2 \qquad (2)$$

where $H_{i,\pm b} = \Delta I_{i,\pm b} \otimes \left[1\ P_{i,\pm b}^T 1\ G_i^T\right]$, $\forall i \in N_t$; $H \in \mathbb{R}^{N_t \times 2(N_p N_\lambda + 1)*(N_p N_\lambda)}$. Note that the $\pm b$ notation describes two biases, and as such the minimization comprises a minimization of a pair of functions: one for the +b bias and one for the -b bias.

In an embodiment, the symmetric proxy may comprise a sum of the measurement values (e.g., intensities or phase differences) from a pair of complementary diffraction orders. In an embodiment, the asymmetric proxy may comprise a second order measurement value difference comprising a difference of: a first measurement value difference of corresponding diffraction orders (e.g., the normal or +1 order) from each of a first biased (or M) sub-target and second biased (or W) sub-target and a second measurement value difference of corresponding diffraction orders (e.g., the complementary or -1 order) from each of the first biased (or M) sub-target and second biased (or W) sub-target; e.g., using an intensity example:

$$P_{\pm b_{j,\lambda, i}} = I_{j,\lambda,i,\pm b}^{+1} + I_{j,\lambda,i,\pm b}^{-1} \; ; \; \forall j \in N_p \, , \forall \lambda \in N_\lambda, \forall i \in N_t$$

$$G_{j,\lambda,i} = \left( I_{j,\lambda,i,+b}^{+1} - I_{j,\lambda,i,-b}^{+1} \right) - \left( I_{j,\lambda,i,+b}^{-1} - I_{j,\lambda,i,-b}^{-1} \right); \forall j \in N_p \, , \forall \lambda \in N_\lambda, \forall i \in N_t$$

Once the trained, the training parameters $M_{\pm b}$ and $N_{\pm b}$ can be used to infer overlay $v_{\pm,i}$ from measured asymmetry signals $\Delta I_{\pm b,i}$:

$$v_{\pm b,i} = \text{vect}(\text{diag}\left( \begin{bmatrix} \mathbf{1} \, P_{\pm b,i} \end{bmatrix}^{\mathrm{T}} \mathbf{1} \, G_i^{\mathrm{T}} \right) \begin{bmatrix} M_{\pm b} \\ N_{\pm b} \end{bmatrix} \Delta I_{\pm b,i})) \qquad (3)$$

where the actual true overlay $ov_i$ per target $i$ can be determine via reverse transformation of the two values: $v_{+,i}$, $v_{-,i}$ and averaging these values:

$$\begin{cases} ov_{+b,i} := \dfrac{P}{2\pi} \text{asin}\,(v_{+b,i} - b) \\ ov_{-b,i} := \dfrac{P}{2\pi} \text{asin}\,(v_{-b,i} + b) \end{cases} ; \; ov_i = \dfrac{ov_{+b,i} + ov_{-b,i}}{2}$$

For the cDBO embodiment, the overlay equation may be defined as:

$$\begin{matrix} Minimize \\ \mathbf{M, N} \end{matrix} \left\| ov_c - vect(diag(\begin{bmatrix} \mathbf{1} \, P_c^{\,T} \mathbf{1} \, G_c^{\,T} \end{bmatrix}) \begin{bmatrix} M_c \\ N_c \end{bmatrix} \Delta\phi_c)) \right\|^2$$

$$\Delta\phi_{\lambda,i,c} = \left( \phi_{\lambda,i,W}^{+1} - \phi_{\lambda,i,M}^{+1} \right) + \left( \phi_{\lambda,i,W}^{-1} - \phi_{\lambda,i,M}^{-1} \right)$$

$$\Delta\phi, \; P, \; G \in \mathbb{R}^{N_\lambda \times N_t}$$

$$\forall \lambda \in N_\lambda, \forall i \in N_t, \forall c \in N_{clusters}$$

In such a cDBO embodiment, the proxies may be defined independently per cluster as indicated by the subscript c: $P_c$ and $G_c$.

In addition, since phase differences between M and W pads and the amplitude of each of the pads are measured, either one or both of two different asymmetry proxies may be defined:

$$P_{j,\lambda,i} = a_{j,\lambda,i,\mathrm{M}}^{+1} + a_{j,\lambda,i,\mathrm{M}}^{-1} + a_{j,\lambda,i,\mathrm{w}}^{+1} + a_{j,\lambda,i,\mathrm{w}}^{-1}$$

$$G_{\lambda,i,c} = \left( \phi_{\lambda,i,W}^{+1} - \phi_{\lambda,i,M}^{+1} \right) - \left( \phi_{\lambda,i,W}^{-1} - \phi_{\lambda,i,M}^{-1} \right)$$

and/or

$$G_{\lambda, i, c} = \frac{a_{\lambda,i,M}^{+1} - a_{\lambda,i,M}^{-1}}{a_{\lambda,i,M}^{+1} + a_{\lambda,i,M}^{-1}} + \frac{a_{\lambda,i,w}^{+1} - a_{\lambda,i,w}^{-1}}{a_{\lambda,i,w}^{+1} + a_{\lambda,i,w}^{-1}}$$

where $a_{M/W} = (I_{max} - I_{min})_{M/W}$.

In embodiments with three (or more) proxies, there needs to be defined additional respective training parameters, e.g., a third magnitude/sensitivity matrix, e.g. $\begin{bmatrix} M \\ N \\ O \end{bmatrix}$. Multiple symmetric and/or asymmetric proxies may be defined. In such an embodiment, each proxy may comprise a variable that correlates with a particular type of process variation. For example, a three proxy embodiment may comprise a first (symmetric) proxy which correlates with symmetric process variations, a second (asymmetric) proxy which correlates with e.g., dSWA and a third (asymmetric) proxy which correlates with e.g., floor tilt. In this way, the contribution of each process variation to the overlay signal can be better distinguished and thus a better model defined to extract/suppress the effect from the overlay signal. Since in cDBO there is access to both amplitude and phase measurement, there are more signal dimensions to identify relevant proxies. However, additional (e.g., more than two) proxies may also in general be defined for μDBO.

The models disclosed herein may be derived as follows (this derivation is provided in terms of a μDBO example, although the concepts are broadly similar for cDBO). For a single pixel, single wavelength λ and single target position on the wafer, and assuming the 2-biased grating target design (per direction) of μDBO (e.g., as illustrated in Figure 4), the 2-wave model for 1D signal extraction can be written as:

$$\Delta I_{j,\lambda, i, \pm b_i} = K_{j,\lambda,i} \sin\left(\frac{2\pi}{P}(ov_i \pm b_i)\right); \ \forall j \in N_p, \forall \lambda \in N_\lambda, \forall i \in N_t$$

where $\Delta I_{j, \lambda, i, \pm b_i} = I_{j,\lambda,i,\pm b_i}^{+1} - I_{j,\lambda,i,\pm b_i}^{-1}$. In the single wavelength overlay inference method, $K$ is eliminated with biased gratings and is computed as:

$$K = \frac{\Delta I_{+b} - \Delta I_{-b}}{2b}$$

The proposed method, in contrast to present methods based on eliminating K, exploits $K$ to learn about the process variations. It can be shown that $K$ is correlated to symmetric process variations and asymmetric process variations. In other words, while only the asymmetric part of the intensity signal is typically used, symmetric variations are included due to the dependence of K to symmetric variations. Therefore, K can be used as a proxy for the process variations in a training-based algorithm.

Applying a change of variable and simplifying the notations as:

$$v_i := \sin(ov_i \pm b_i), \ \Delta I_{j,\lambda,i} := \Delta I_{j,\lambda,i,\pm b_i}$$

A linear transformation may be used instead of the sine transformation here. Rearranging the equation to describe sensitivity of overlay parameter $v$ to a change in the measured signal $\Delta I$ (instead of sensitivity of $\Delta I$ to change in $v$) yields: .

$$v_i = w_{j,\lambda,i}\Delta I_{j,\lambda, i}; \ \forall j \in N_p, \forall \lambda \in N_\lambda, \forall i \in N_t$$

where weight w = $K^{-1}$

The two-wave model may be expanded by defining proxies $P_{j,\lambda,i}, G_{j,\lambda,i}$ for symmetric and asymmetric process variations. To do so, the weights related to symmetric and asymmetric process variations may be separated and the estimation model rewritten as:

$$v_i = (z_{j,\lambda} + r_{j,\lambda})\Delta I_{j,\lambda,i}; \quad \forall j \in N_p, \forall \lambda \in N_\lambda, \forall i \in N_t$$

where $w_{j,\lambda} = (z_{j,\lambda} + r_{j,\lambda})$, with $z_{j,\lambda}$ and $r_{j,\lambda}$ comprising weights that are a function of symmetric and asymmetric process variations respectively:

Symmetric process variations: $z_{j,\lambda}(P_{j,\lambda,i})$:

$$P_{j,\lambda,i} = I^{+1}_{j,\lambda,i,\pm b} + I^{-1}_{j,\lambda,i,\pm b}$$

Asymmetric process variations: $r_{j,\lambda}(G_{j,\lambda,i})$;

$$G_{j,\lambda,i} = \Delta I_{j,\lambda,i,+b} - \Delta I_{j,\lambda,i,-b} = \left(I^{+1}_{j,\lambda,i,+b} - I^{-1}_{j,\lambda,i,+b}\right) - \left(I^{+1}_{j,\lambda,i,-b} - I^{-1}_{j,\lambda,i,-b}\right)$$

$$= \left(I^{+1}_{j,\lambda,i,+b} - I^{+1}_{j,\lambda,i,-b}\right) - \left(I^{-1}_{j,\lambda,i,+b} - I^{-1}_{j,\lambda,i,-b}\right)$$

i.e., the difference between the images of both biases of the normal or +1 diffraction order and the complementary or -1 diffraction order.

It can be assumed that $z_{j,\lambda}$ and $r_{j,\lambda}$ are generic unknown functions of $P_{j,\lambda,i}$ and $G_{j,\lambda,i}$ respectively. The dependence on wavelength and pixels may be dropped by vectorizing $z_{j,\lambda}, r_{j,\lambda}, P_{j,\lambda,i}$ and $G_{j,\lambda,i}$ for all the considered wavelengths and pixels, yielding $z \in \mathbb{R}^{N_p N_\lambda \times 1}$, $r \in \mathbb{R}^{N_p N_\lambda \times 1}$, $P_i \in \mathbb{R}^{N_p N_\lambda \times 1}$ and $G_i \in \mathbb{R}^{N_p N_\lambda \times 1}$ for the ith target. Linearizing the dependence of $z$ on $P_i$ and $r$ on $G_i$ around a nominal operating point, yields:

$$z^T(P_i) = z_0^T(\overline{P_i}) + (P_i - \overline{P_i})^T M_s$$

$$r^T(P_i) = r_0^T(\overline{G_i}) + (G_i - \overline{G_i})^T N_a$$

Defining $m_o^T = z_0^T(\overline{P_i}) - \overline{P_i}^T M$ and $M = \begin{bmatrix} m_0^T \\ M_s \end{bmatrix}$ where $M \in \mathbb{R}^{(1+N_p N_\lambda)\times(N_p N_\lambda)}$, yields:

$$z^T(P_i) = \begin{bmatrix} 1 & P_i^T \end{bmatrix} M$$

Similarly, defining $n_o^T = r_0^T(\overline{G_i}) - \overline{G_i}^T N_a$ and $N = \begin{bmatrix} n_0^T \\ N_a \end{bmatrix}$ where $N \in \mathbb{R}^{(1+N_p N_\lambda)\times(N_p N_\lambda)}$ yields:

$$r^T(G_i) = \begin{bmatrix} 1 & G_i^T \end{bmatrix} N$$

Combining the above, the overlay inference model becomes:

$$\begin{cases} v_i = (z^T(P_i) + r^T(G_i))\Delta I_i \\ \quad z^T(P_i) = \begin{bmatrix} 1 & P_i^T \end{bmatrix} M \\ \quad r^T(GI_i) = \begin{bmatrix} 1 & G_i^T \end{bmatrix} N \end{cases} \rightarrow v_i = \left(\begin{bmatrix} 1 & P_i^T \end{bmatrix} M + \begin{bmatrix} 1 & G_i^T \end{bmatrix} N\right) \Delta I_i$$

The model and theory outlined above rely on there being known training labels or known parameter of interest values (e.g., overlay) for the training data. Such known values may be measured using accurate metrology techniques such as scanning electron microscopy, for example, or obtained by any other suitable method. The known values may comprise scanner set values for wafers with programmed overlay. Where training data comprises simulated data (training data may be measured and/or simulated), the parameter of interest/overlay values may be the simulated values. However reference values may not always be available. As such, a self-referencing embodiment will now be described which is an adaption of the embodiment described above.

In this embodiment, it is proposed to find the model training parameters $\begin{bmatrix} M \\ N \end{bmatrix}$ using all the target positions collectively, based on the assumption that overlay on both sub-targets must be the same:

$$ov_{+b} := ov_{-b} \Rightarrow 2b - (v_{+b} - v_{-b}) = 0 \, ;$$

where:

$$ov_{+b} := v_{+b} - b$$

$$ov_{-b} := v_{-b} + b$$

It is also assumed that $v_{+b}$ and $v_{-b}$ can be captured by the same model, i.e., $\begin{bmatrix} M \\ N \end{bmatrix} = \begin{bmatrix} M_{+b} \\ N_{+b} \end{bmatrix} = \begin{bmatrix} M_{-b} \\ N_{-b} \end{bmatrix}$. As such, the training problem comprises solving a single minimization problem to minimize $\begin{bmatrix} M \\ N \end{bmatrix}$, while in the previous embodiment, the training problem comprising solving a pair of minimization problems (one cost function per sub-target bias +b, -b) to minimize $\begin{bmatrix} M_{+b} \\ N_{+b} \end{bmatrix}$ and $\begin{bmatrix} M_{-b} \\ N_{-b} \end{bmatrix}$.

Therefore, to insert the equality in $v$ space yields for the training problem:

$$\underset{\begin{bmatrix} M \\ N \end{bmatrix}}{Minimize} \, \| 2b\mathbf{1} - (\text{vect}\left( \text{diag}\left( [\mathbf{1} \, P_{+b}^T \mathbf{1} \, G^T] \begin{bmatrix} M \\ N \end{bmatrix} \Delta I_{+b} \right) \right)$$
$$- \text{vect}\left( \text{diag}\left( [\mathbf{1} \, P_{-b}^T \mathbf{1} \, G^T] \begin{bmatrix} M \\ N \end{bmatrix} \Delta I_{-b} \right) \right) ) \|^2$$

which may be conveniently written as:

$$\underset{\begin{bmatrix} M \\ N \end{bmatrix}}{Minimize} \, \| 2b\mathbf{1} - \left( (H_{+b} - H_{-b}) vec\left( \begin{bmatrix} M \\ N \end{bmatrix} \right) \right) \|^2 \qquad (4)$$

where:

$$H_{i,\pm b} = \Delta I_{i,\pm b} \otimes [\mathbf{1} \, P_{i,\pm b}^T \mathbf{1} \, G_i^T]; \, \forall i \in N_t$$

This training is completely self-referenced, with the training using the known bias $b$ of the sub-targets in place of external overlay values.

In an inference phase or manufacturing phase, the overlay can be determined from the following equation.

$$\begin{bmatrix} v_{+b,i} \\ v_{-b,i} \end{bmatrix} = \text{vect}(\text{diag}(\begin{bmatrix} 1 \ P_{+b,i}{}^{\mathrm{T}} \ 1 \ G_i{}^{\mathrm{T}} \\ 1 \ P_{-b,i}{}^{\mathrm{T}} \ 1 \ G_i{}^{\mathrm{T}} \end{bmatrix} \begin{bmatrix} M \\ N \end{bmatrix} [\Delta I_{+b,i} \ \Delta I_{-b,i}])) \qquad (5)$$

once again, this is a single equation rather than the pair of equations (one per bias) of the previous external referenced embodiment, such that the signals $\Delta I_{+b,i}$ $\Delta I_{-b,i}$ from the sub-targets of both biases are used together. The transformed overlay values $v_{+b,i}$, $v_{+b,i}$ can then be reverse transformed and averaged as with the previous embodiment to determine a final overlay value $ov$ for each target.

For a cDBO self-referenced embodiment, the following assumptions may be made:

$$ov_{c1} = ov_{c2} \rightarrow ov_{c1} - ov_{c2} = 0 \; ;$$

$$\begin{bmatrix} M \\ N \end{bmatrix} = \begin{bmatrix} M_{c1} \\ N_{c1} \end{bmatrix} = \begin{bmatrix} M_{c2} \\ N_{c2} \end{bmatrix}$$

where c1 and c2 indicate respective different (e.g., centrosymmetric) target clusters of a pair of clusters. This training may then be performed to enforce this equality; i.e., find the training parameters which minimize the difference between overlay inference between two (or more) centrosymmetric target design clusters. The training equation in this can be written as:

$$\underset{\begin{bmatrix} M \\ N \end{bmatrix}}{Minimize} \; \left\| \left(vect\left(diag\left(\begin{bmatrix} 1 \ P_{c1}{}^{T} \ 1 \ G_{c1}{}^{T} \end{bmatrix} \begin{bmatrix} M \\ N \end{bmatrix} \Delta\phi_{c1}\right)\right)\right.$$

$$\left. - \; vect\left(diag\left(\begin{bmatrix} 1 \ P_{c2}{}^{T} \ 1 \ G_{c2}{}^{T} \end{bmatrix} \begin{bmatrix} M \\ N \end{bmatrix} \Delta\phi_{c2}\right)\right)\right) \right\|^2$$

and, once trained, overlay may be determined from:

$$ov_c = vect(diag(\begin{bmatrix} 1 \ P_c{}^{T} \ 1 \ G_c{}^{T} \end{bmatrix} \begin{bmatrix} M_c \\ N_c \end{bmatrix} \Delta\phi_c))$$

with the final overlay comprising the average of the overlay of the two clusters ($i$ is the target position index):

$$ov_i = \frac{ov_{i,c1} + ov_{i,c2}}{2}$$

A proposed method based on the above concepts may comprise two phases: a recipe setup phase or training phase (which may be combined with present qualification processes); and a manufacturing phase or overlay inference phase.

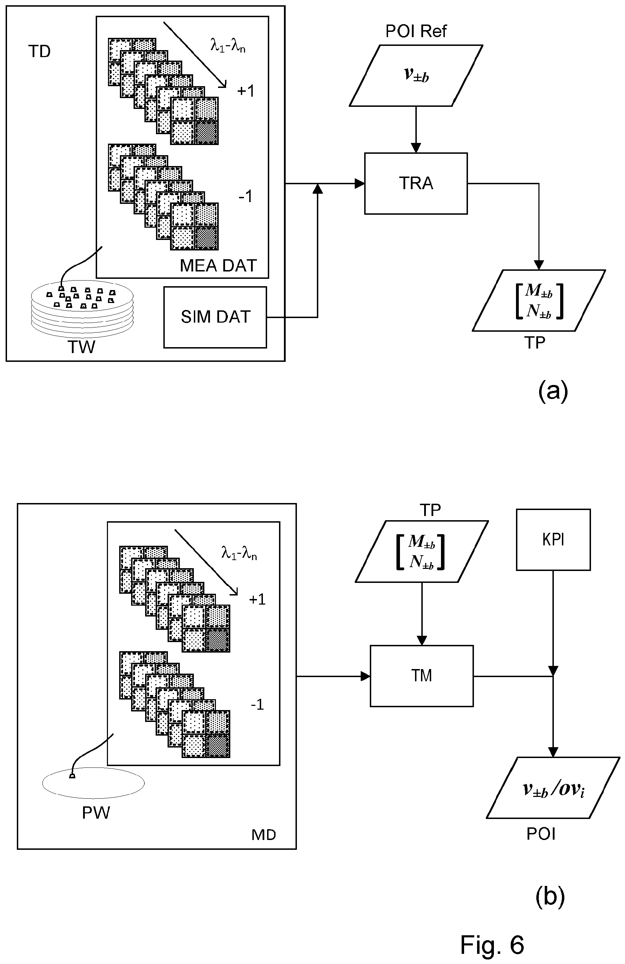

Figure 6 is a flow diagram illustrating a first embodiment, or externally referenced embodiment. Figure 6(a) is a flow diagram illustrating a training phase for this embodiment. Training data TD comprises one or both of: measured data MEA DAT obtained by measurements performed on one or more training wafers TW and simulated data SIM DAT (e.g., as obtained using computation lithography techniques). In each case, the training data may relate to for two (or more) complementary diffraction orders (e.g., the +1 and -1 orders) for each of a plurality of different wavelengths $\lambda_1$-$\lambda_n$ and a plurality of different target positions (e.g., all target positions on the wafer). The targets may comprise two biases (or two biases per direction in the substrate plane) such as illustrated in Figure 4, or else may be cDBO targets as has been described. The targets should all be similar. The measurement data may comprise a single measurement value per sub-target or pad (e.g., averaged over an ROI), a measurement value per pixel or a measurement value for image regions or groups of pixels (e.g., an averaging over an intermediate granularity between the two listed extremes).

In addition to the training data, external reference data POI Ref comprising known reference values for the parameter of interest (e.g., known overlay values) is obtained. This may comprise measured values (e.g., using SEM metrology), other AEI references or (scanner model corrected) scanner set values for wafers with programmed overlay for measured data MEA DAT and/or programmed/computed/set values for the simulated data SIM DAT.

The reference data POI Ref and training data TD is used in a training or optimization step TRA to find/train at least the training parameters TP $M_{\pm b}$, $N_{\pm b}$ (or per cluster in a cDBO example). Of course, there will be more training parameters in embodiments with more proxies defined. This step may use the minimization function Equation 2, and may be solved via a closed form solution and/or multi-pixel version (as will be described). In this training phase, the parameter estimation problem distills to an optimization problem to be solved simultaneously for the model parameters over multiple dimensions (e.g., intensity, wavelength and target position on the wafer). This training phase can be performed in-line or offline.

Figure 6(b) is a flow diagram illustrating the inference phase or production phase. Measurement data MD comprising measurement values from a production wafer PW for two (or more) complementary diffraction orders (e.g., the +1 and -1 orders) for each of a plurality of different wavelengths $\lambda_1$-$\lambda_n$, which may be the same wavelengths as the training phase or a smaller (proper) subset of the wavelengths used for training (e.g., a small subset such as fewer than 6, fewer than 5, fewer than 4 or fewer than 3 wavelengths). Measurement data MD may relate to one or more target positions.

In the inference phase, the parameter of interest POI of the new measurement data MD is computed using the trained model TM, based on the training parameters TP (e.g., $M_{\pm b}$,$N_{\pm b}$) determined in the training phase. This may be done using Equation (3) for example. The parameter of interest POI inference can be done collectively for all the targets, a subset of all targets of on a per-target basis. In this phase, to prevent deviation from the process during manufacturing, it is optionally proposed to use one or more monitoring KPIs. These KPIs can be used identify a drift from the trained model TM. The monitoring KPIs can flag changes for which the learned model is not sufficiently descriptive. This can be used within a control loop to trigger a further recipe set up or training phase.

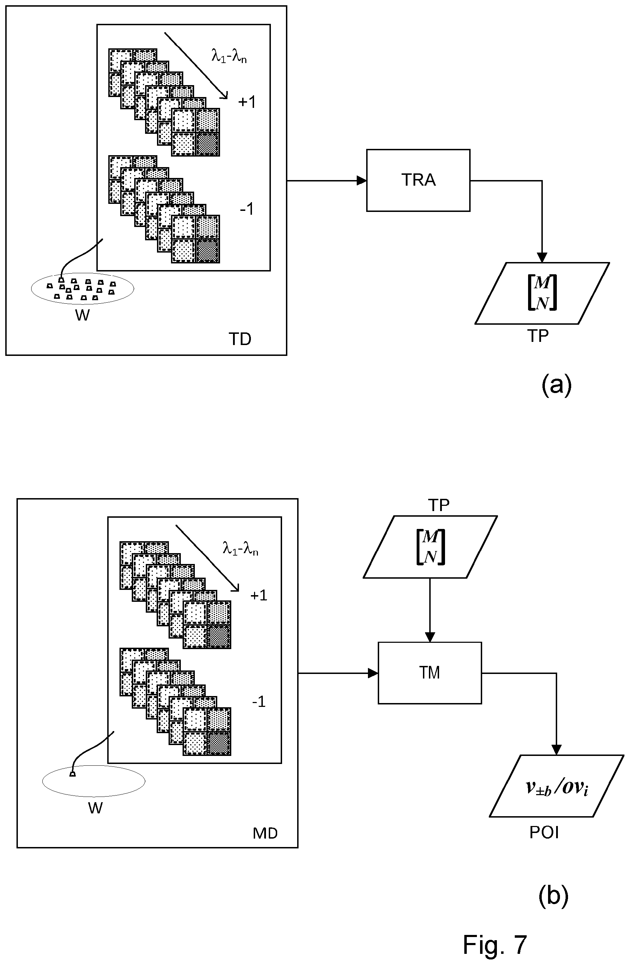

Figure 7 comprise equivalent flow diagrams to those of Figure 6, for the self-referenced embodiment. In this embodiment, and referring to training phase illustrated by Figure 7(a), the training data TD is obtained from a wafer W. Training data TD comprises measured data MEA DAT obtained by measurements performed said wafer W for two (or more) complementary diffraction orders (e.g., the +1 and -1 orders) for each of a plurality of different wavelengths $\lambda_1$-$\lambda_n$ and a plurality of different target positions (e.g., all target positions on the wafer W). As before, the measurement data may comprise a single measurement value per sub-target or pad (e.g., averaged over an ROI), a measurement value per pixel or a measurement value for image regions or groups of pixels (e.g., an averaging over an intermediate granularity between the two listed extremes).

The training data TD is used in a training or optimization step TRA to find/train the training parameters TP $M$, $N$. This step may use the minimization function Equation 4, and may be solved via a closed form solution and/or multi-pixel version (as will be described). No external reference is used, the training being done on the known biases.

Figure 7(b) is a flow diagram illustrating the inference phase or production phase of this self-referenced embodiment. Measurement data MD comprises measurement values of a single target on the same wafer W as used for the training. Again this measurement data MD may relate to two (or more) complementary diffraction orders (e.g., the +1 and -1 orders) for each of a plurality of different wavelengths $\lambda_1$-$\lambda_n$, which may be the same wavelengths as the training phase or a smaller (proper) subset of the wavelengths used for training (e.g., a small subset such as fewer than 6, fewer than 5, fewer than 4 or fewer than 3 wavelengths). The parameter of interest POI of the new measurement data MD is computed using the trained model TM, based on the training parameters TP $M$, $N$ determined in the training phase. This may be done using Equation (5) for example. The parameter of interest POI inference is done on a per-target basis in this embodiment.

**Closed form solution of the optimization problem**

The proposed multi-dimensional regression problem has a closed form solution. The external referenced problem (Equation (2)) may be rewritten as:

$$\underset{x}{Minimize}\ \|v_{\pm b} - H_{\pm b}vec(\begin{bmatrix} M_{\pm b} \\ N_{\pm b} \end{bmatrix})\|^2$$

where $x = vec(\begin{bmatrix} M_{\pm b} \\ N_{\pm b} \end{bmatrix})$

The solution, in the training phase can be found by computing the pseudo-inverse as:

$$x = vec\left(\begin{bmatrix} M_{\pm b} \\ N_{\pm b} \end{bmatrix}\right) = H_{\pm b}^+\ v_{\pm b} = V_h \Sigma_h^{-1} U_h^T v_{\pm b}$$

where $H^+$ indicates the pseudo-inverse of $H$. Additionally, to avoid instability and apply regularization, the modes used in computing the pseudo-inverse $H^+$ may be restricted by applying a threshold on the singular values of $H$.

After computing $M, N$ in the training phase, the overlay vector $v_{\pm b}$ may be computed as:

$$v_{\pm b} = vect\left(diag\left(\begin{bmatrix} 1 & P_{\pm b}{}^T 1 & G^T \end{bmatrix} \begin{bmatrix} M \\ N \end{bmatrix} \Delta I_{\pm b}\right)\right)$$

Similarly, for the self-referenced embodiment, a closed form solution of Equation (4) may be:

$$vec\left(\begin{bmatrix} M \\ N \end{bmatrix}\right) = (H^+)2b1 = (V_h \Sigma_h^{-1} U_h^T)2b1$$

where $H = H_{+b} - H_{-b}$

A closed form solution for the cDBO embodiments can be constructed similarly, as will be apparent to the skilled person.

We can also add explicit regularization to the optimization problem. For example, the optimization problem by adding Tikhonov regularization can be written as

$$\underset{x}{Minimize}\|v_{\pm b} - H_{\pm b}x\|^2 + \lambda\|x\|^2$$

where $x = vec\left(\begin{bmatrix} M_{\pm b} \\ N_{\pm b} \end{bmatrix}\right)$. This leads to the closed form solution:

$$vec\left(\begin{bmatrix} M_{\pm b} \\ N_{\pm b} \end{bmatrix}\right) = ((H_{\pm b}{}^T H_{\pm b} + \gamma I)^{-1} H_{\pm b}{}^T) v_{\pm b}$$

Similar regularized formulation can also be stated for the self-reference version leading to the closed-form solution

$$vec\left(\begin{bmatrix} M \\ N \end{bmatrix}\right) = ((H^T H + \gamma I)^{-1} H^T)2b1$$

## Multi-pixel Embodiment

As has been described, it is possible to solve the regression problem using the information from multiple pixels within the image ROI. The above described regression problems may be solved for multiple pixels $N_p$, or with $N_p$ set to 1 (standard averaging within the ROI).

However, if multiple pixels information is to be used, the known data matrices $P$, $G$, $\Delta I$ have the size $N_p N_\lambda \times N_t$ and the unknown training matrices $M, N \in \mathbb{R}^{(N_p N_\lambda + 1) \times (N_p N_\lambda)}$. To be able to solve the problem efficiently, a data reduction step is proposed to reduce the number of free parameters. This may be achieved by applying a data compression using singular value decomposition (SVD) as follows:

In the training phase, SVD is applied on each of the data matrices $P$, $G$, $\Delta I$:

$$\begin{cases} P = U_p \Sigma_p V_p^T \\ G = U_g \Sigma_g V_g^T \\ \Delta I = U_a \Sigma_a V_a^T \end{cases}$$

where $U_{p,g,a} \in \mathbb{R}^{N_p N_\lambda \times N_p N_\lambda}$ is the left singular vector, $\Sigma_{p,g,a} \in \mathbb{R}^{N_p N_\lambda \times N_t}$ is a diagonal matrix containing the singular values and $V_{p,g,a} \in \mathbb{R}^{N_t \times N_t}$ is the right singular vector.

The compressed version of the data matrices, i.e. $P_c$, $G_c$, $\Delta I_c$ may be calculated as:

$$\begin{cases} P_c = \widetilde{U_p}^T P \\ G_c = \widetilde{U_g}^T G \\ \Delta I_c = \widetilde{U_a}^T \Delta I \end{cases}$$

Where $\widetilde{U_p} \in \mathbb{R}^{N_p N_\lambda \times q_p}$, $\widetilde{U_g} \in \mathbb{R}^{N_p N_\lambda \times q_g}$, $\widetilde{U_a} \in \mathbb{R}^{N_p N_\lambda \times q_a}$ are respectively the first $q_p$, $q_g$ and $q_a$ columns of the matrices $U_p, U_g$ and $U_a$. In this case, $q_p, q_g$ and $q_a$ are the compression length of the data matrices and are chosen such that the data matrices are adequately approximated by these number of modes.

Applying the data compression, the regression problem (Equation 2) can be rewritten as:

$$\underset{\begin{bmatrix} M_{r,\pm b} \\ N_{r,\pm b} \end{bmatrix}}{Minimize} \left\| v_{\pm b} - vect\left(diag\left(\begin{bmatrix} 1 & P_{\pm b}^T & 1 & G^T \end{bmatrix}\begin{bmatrix} \overline{U_p} & 0 \\ 0 & \overline{U_g} \end{bmatrix}\begin{bmatrix} M_{r,\pm b} \\ N_{r,\pm b} \end{bmatrix}\widetilde{U_a}^T \Delta I_{\pm b}\right)\right) \right\|^2$$

where $\overline{U_p} \in \mathbb{R}^{N_p N_\lambda \times (q_p+1)}$ and $\overline{U_g} \in \mathbb{R}^{N_p N_\lambda \times (q_g+1)}$ are the reduced left singular vectors $\widetilde{U_p}$, $\widetilde{U_g}$ extended in the diagonal with 1 and $M_r \in \mathbb{R}^{(1+q_p) \times q_p}$ and $N_r \in \mathbb{R}^{(1+q_g) \times q_g}$ are the reduced versions of training matrices $M, N,$ and where:

$$\begin{bmatrix} M \\ N \end{bmatrix} = \begin{bmatrix} \overline{U_p} & 0 \\ 0 & \overline{U_g} \end{bmatrix}\begin{bmatrix} M_r \\ N_r \end{bmatrix}\widetilde{U_a}^T$$

This regression problem can be equivalently written as:

$$\underset{\begin{bmatrix} M_{r,\pm b} \\ N_{r,\pm b} \end{bmatrix}}{Minimize} \left\| v_{\pm b} - vect\left(diag\left(\begin{bmatrix} 1 & P_{c,\pm b}^T & 1 & G_c^T \end{bmatrix}\begin{bmatrix} M_{r,\pm b} \\ N_{r,\pm b} \end{bmatrix}\Delta I_{c,\pm b}\right)\right) \right\|^2$$

To find the solution of this optimization problem, the compressed version of the data matrices ($P_c$, $G_c$ and $\Delta I_c$) may be used to train the reduced version of the training parameter matrices ($M_r$, $N_r$). For example, the training phase may comprise solving:

$$\begin{bmatrix} M_{r,\pm b} \\ N_{r,\pm b} \end{bmatrix} = vec\left(\begin{bmatrix} M_{r,\pm b} \\ N_{r,\pm b} \end{bmatrix}\right) = H_{c,\pm b}^+ v_{\pm b} = V_{hc}\Sigma_{hc}^{-1}U_{hc}^T v_{\pm b}$$

and in the inference phase, the overlay values may be obtained via:

$$v_{\pm} = vect\left(diag\left(\begin{bmatrix} 1 & P_{c,\pm b}^T & 1 & G_c^T \end{bmatrix}\begin{bmatrix} M_{r,\pm b} \\ N_{r,\pm b} \end{bmatrix}\Delta I_{c,\pm b}\right)\right)$$

This approach may be adapted and used for the self-referenced embodiment and/or a cDBO embodiment, as will be apparent to the skilled person.

It can also be appreciated that a dimension reduction step such as an SVD step may be applied independently of an individual pixel treatment, e.g., it may be applied to any of the other embodiments disclosed herein.

**Reducing Target Size**

In an embodiment, the overlay methods disclosed herein may allow removal of one biased grating (e.g., per direction) from the μDBO target, thereby halving the target area. Similarly cDBO targets may be made smaller (e.g., halved in size) by having only one cluster (e.g., only one M pad and W pad) per cDBO target. As such, targets with only a single sub-target per direction having a single bias or no bias, (μDBO) or two sub-targets, one each of an M pad and W pad (cDBO) can be used for inline ADI overlay monitoring.

In a first variation of such an embodiment, the bias may be varied over different single-biased target (the scope of the term "single biased target" encompasses a zero biased/unbiased target in this context), to provide a collective multi-bias. As such, each wafer may comprise multiple targets, all of which have a single bias (optionally per direction), but with the bias varied between targets such that there are two (or more) biases on the wafer. This enable the proxies $P_{j,\lambda,i}$ and $G_{j,\lambda,i}$ to be defined in the same way as already described; in particular it allows the asymmetric proxy $G_{j,\lambda,i}$ to be used, this proxy relying on there being different biases to determine the second order difference, as has been described. More specifically, to determine the asymmetric proxy in such an embodiment, the required signal differences

$$\left(I_{j,\lambda,i,+b}^{+1} - I_{j,\lambda,i,-b}^{+1}\right) \text{ and } \left(I_{j,\lambda,i,+b}^{-1} - I_{j,\lambda,i,-b}^{-1}\right)$$ between the differently biased sub-targets can now be obtained from different target positions, rather than from the same target position (i.e., $I_{j,\lambda,i,+b}^{+1}$, $I_{j,\lambda,i,+b}^{-1}$ relate to a different target position than $I_{j,\lambda,i,-b}^{+1}$, $I_{j,\lambda,i,-b}^{-1}$). The two target positions used to determine the asymmetric proxy in such an embodiment may be close or adjacent, where it may be assumed that the asymmetric process effect is similar for the two target locations.

A similar distributed approach may be applied to cDBO targets, where the targets on a wafer may comprise first targets of a first cluster type at some wafer locations, and targets of a second cluster type at other wafer locations.

In an alternative embodiment, all the targets on the wafer can have the same single bias/same cluster type. However, for the μDBO embodiments, this only allows the symmetric proxy to be used. As such, in such a μDBO embodiment, the asymmetric proxy is omitted or set to zero: $G_{j,\lambda,i} = 0$, and its corresponding training parameter $N_{\pm b}$ not trained nor used in inference.

In summary, an ADI metrology method is described, usable in fast metrology techniques (e.g., dark-field metrology) for inline overlay monitoring. As such, this approach extends training-based inference methods to dark-field applications. The method incorporates both asymmetric process variations and symmetric process variations into the model.

Such an approach can improve accuracy and robustness against process variations, due to the fact that the method may be used to estimate overlay collectively on multiple target positions on the wafer. The proposed methods may be used to reduce target size. Additionally, the methods allow pixel intensity information from the dark-field images to be incorporated in the overlay inference problem. This provides opportunity for a co-development of calibration and inference methods within the same framework, incorporation of pixel-selection and ROI-refinement methods, such as pixel mapping, directly inside the overlay inference.

As has been mentioned, while the embodiments disclosed have largely been described in relation to μDBO or more generally intensity based applications, the same methods can be extended to use in the cDBO or more generally phase based applications application..

While the targets described above are metrology targets specifically designed and formed for the purposes of measurement, in other embodiments, properties may be measured on targets which are functional parts of devices formed on the substrate. Many devices have regular, grating-like structures. The terms 'target grating' and 'target' as used herein do not require that the structure has been provided specifically for the measurement being performed. In such an embodiment, either the target gratings and mediator grating may all comprise product structure, or only one or both target gratings comprise product structure, with the mediator grating being specifically formed to mediate the allowable pitches, and therefore enable measurements directly on the product structure. Further, pitch of the metrology targets is close to the resolution limit of the optical system of the scatterometer, but may be much larger than the dimension of typical product features made by lithographic process in the target portions C. In practice the lines and/or spaces of the overlay gratings within the targets may be made to include smaller structures similar in dimension to the product features.

An embodiment may include a computer program containing one or more sequences of machine-readable instructions describing methods of measuring targets on a substrate and/or analyzing measurements to obtain information about a lithographic process. This computer program may be executed for example within unit PU in the apparatus of Figure 3 and/or the control unit LACU of Figure 2. There may also be provided a data storage medium (e.g., semiconductor memory, magnetic or optical disk) having such a computer program stored therein. Where an existing metrology apparatus, for example of the type shown in Figure 3, is already in production and/or in use, the invention can be implemented by the provision of updated computer program products for causing a processor to perform the steps necessary to calculate the overlay error.

The program may optionally be arranged to control the optical system, substrate support and the like to perform the steps necessary to calculate the overlay error for measurement of asymmetry on a suitable plurality of targets.

Further embodiments according to the invention are presented in below numbered clauses:

1. A method for determining a parameter of interest relating to at least one target on a substrate, the method comprising: obtaining metrology data comprising at least one asymmetry signal, said at least one asymmetry signal comprising a difference or imbalance in a measurement parameter from the target; obtaining a trained model having been trained or configured to relate said at least one asymmetry signal to the parameter of interest, the trained model comprising at least one proxy for at least one nuisance component of the at least one asymmetry signal; and inferring said parameter of interest for said at least one target from said at least one asymmetry signal using the trained model.

2. A method according to clause 1, wherein said metrology data comprises after-develop metrology data, measured prior to an etch step for the layer just exposed.

3. A method according to clause 1 or 2, wherein said at least one asymmetry signal comprises at least one asymmetry signal measured at an image plane or conjugate thereof of a metrology tool used to obtain said metrology data.

4. A method according to any preceding clause, wherein said trained model comprises a configured training parameter for each of said at least one proxies.

5. A method according to any preceding clause, wherein said at least one proxy comprises one or both of: at least one symmetric proxy for a symmetric nuisance component of each asymmetry signal of the at least one asymmetry signal; and/or at least one asymmetric proxy for an asymmetric nuisance component of each asymmetry signal of the at least one asymmetry signal.

6. A method according to clause 5, wherein said at least one asymmetry signal comprises: a measurement parameter asymmetry between each diffraction order of a pair of complementary diffraction orders.

7. A method according to clause 6, wherein said measurement parameter is intensity or a related parameter.

8. A method according to clause 6 or 7, wherein the at least one symmetric proxy comprises a sum of respective measurement parameter values from each diffraction order of a pair of complementary diffraction orders.

9. A method according to clause 6, 7 or 8, wherein the at least one asymmetric proxy comprises a difference of: a first measurement parameter value difference of first corresponding diffraction orders from each of a first sub-target type and a different second sub-target type of said at least one target; and a second measurement parameter value difference of second corresponding diffraction orders complementary to said first corresponding diffraction orders, from each of the first sub-target type and second sub-target type.

10. A method according to clause 9, wherein the first sub-target type and second sub-target type are each comprised within a respective target arrangement at each target location.

11. A method according to clause 9, wherein the first sub-target type and second sub-target type are each distributed over different target locations on the substrate.

12. A method according to any preceding clause, wherein each said at least one target comprises only a single sub-target type, or a single sub-target type per measurement direction.

13. A method according to clause 5, wherein said at least one asymmetry signal comprises a phase difference between radiation scattered by a first sub-target type of said at least one target and radiation scattered by at least a second sub-target type of said at least one target, each sub-target type comprising a first grating and second grating having different pitches, and wherein the order of the gratings is reversed within the target layers between the two sub-target types.

14. A method according to clause 13, wherein said at least one asymmetry signal is determined from an average of said phase differences as obtained from: a first diffraction order of a pair of complementary diffraction orders from each sub-target type and a second diffraction order of the pair of complementary diffraction orders from each sub-target type.

15. A method according to clause 13 or 14, wherein the at least one symmetric proxy comprises a sum of respective amplitude values from each diffraction order of a pair of complementary diffraction orders.

16. A method according to any of clauses 13 to 15, wherein the at least one asymmetric proxy comprises one or both of: a difference of: a first phase difference of first corresponding diffraction orders from each of the first sub-target type and the second sub-target type and a second phase difference of second corresponding diffraction orders complementary to said first corresponding diffraction orders, from each of the first sub-target type and second sub-target type; and/or a sum of: a first amplitude difference, optionally normalized, between complementary diffraction orders of radiation scattered by the first sub-target type and a second amplitude difference, optionally normalized, between complementary diffraction orders of radiation scattered by the second sub-target type.

17. A method according to any of clauses 13 to 16, wherein said at least one target comprises at least a first cluster type comprising a first arrangement of sub-targets comprising at least a first sub-target type and a second sub-target type and a second cluster type comprising a second arrangement of sub-targets comprising at least a first sub-target type and a second sub-target type.

18. A method according to clause 17, wherein the first cluster type and second cluster type are each comprised within a respective target arrangement at each target location.

19. A method according to clause 17, wherein the first cluster type and second cluster type are each distributed over different target locations on the substrate.

20. A method according to any preceding clause, wherein said metrology data comprises a plurality of asymmetry signals relating to a plurality of targets at different target locations; and the step of inferring said parameter of interest comprises simultaneously inferring said parameter of interest for each of said targets using the trained model and said plurality of asymmetry signals.

21. A method according to any of clauses 1 to 19, wherein the step of inferring said parameter of interest comprises inferring said parameter of interest for each target on the substrate individually.

22. A method according to any preceding clause, wherein the trained model was trained using training data comprising a plurality of training asymmetry signals relating to a plurality of training targets which are the same targets, or similar to, said at least one target.

23. A method according to any preceding clause, wherein the trained model was trained using external reference data for the parameter of interest.

24. A method according to clause 23, wherein said trained model comprises a first trained model for inferring a parameter of interest value for a first sub-target type or cluster type of each target of said at least one target and a second trained model for inferring a parameter of interest value for a second sub-target type or cluster type of each of said at least one target; and said inference step comprises: using the first trained model to determine a first parameter of interest value for each first sub-target type or cluster type and using the second trained model to determine a second parameter of interest value for each second sub-target type or cluster type; and inferring said parameter of interest for each target as a combination or average of the first parameter of interest value for the first sub-target type or cluster type of that target and the second parameter of interest value for the second sub-target type or cluster type of that target.

25. A method according to clause 23 or 24, comprising an initial step of performing the method of any of clauses 30 to 41 to train said trained model.

26. A method according to any of clauses 1 to 22, wherein the training of the trained model was self-referenced and said training targets are the same targets on the same substrate as said at least one target.

27. A method according to clause 26, wherein said model assumes the parameter of interest for each sub-target type or sub-target cluster type of said at least one target is the same; and a single model is used to infer the parameter of interest for each sub-target type or sub-target cluster type.

28. A method according to clause 26 or 27, wherein said model was trained on the known bias magnitude of said sub-targets or an assumed common overlay from different sub-target clusters.

29. A method according to clause 26, 27 or 28, comprising an initial step of performing the method of any of clauses 30 to 35, or clause 42 to train said trained model.

30. A method according to any preceding clause, wherein said metrology data comprises a plurality of asymmetry signals from each sub-target of each target of said at least one target, wherein the plurality of asymmetry signals from each sub-target relate to different regions within measurement images of said sub-targets from which said asymmetry signals are derived; wherein said inferring the parameter of interest comprises inferring the parameter of interest using the plurality of asymmetry signals relating to different regions within measurement images of each sub-target individually.

31. A method according to clause 30, wherein each asymmetry signal of said different regions within measurement images of each sub-target, is obtained from a measurement value from corresponding pixels of corresponding measurement images of said sub-target.

32. A method according to any preceding clause, wherein said model is a compressed model comprising a compressed asymmetry signal matrix and compressed matrices for each of said at least one proxy.

33. A method according to any preceding clause, wherein said parameter of interest is overlay.

34. A method according to any preceding clause, wherein the trained model is a multi-dimensional regression model, said dimensions comprising two or more of: diffraction order, sub-target or cluster type, measurement wavelengths, target position on substrate, region within measurement images from which said asymmetry signals are derived.

35. A method according to any preceding clause, comprising performing metrology on said at least one target to obtain said metrology data.

36. A method according to clause 35, wherein said metrology comprises dark-field metrology.

37. A method of training a model to relate asymmetry signals to a parameter of interest, the model comprising at least one proxy for at least one nuisance component of the asymmetry signals, the method comprising: obtaining training data comprising a plurality of training asymmetry signals relating to a plurality of training targets on one or more training substrates; and training said model by optimizing a respective training parameter for each of said at least one proxy.

38. A method according to clause 37, wherein said at least one proxy comprises at least one of: at least one symmetric proxy for a symmetric nuisance component of the at least one asymmetry signal; and/or at least one asymmetric first proxy for an asymmetric nuisance component of the at least one asymmetry signal.

39. A method according to clause 38, wherein said training asymmetry signals each comprise: a measurement parameter asymmetry between each diffraction order of a pair of complementary diffraction orders.

40. A method according to clause 39, wherein said measurement parameter is intensity or a related parameter.

41. A method according to clause 39 or 40, wherein the at least one symmetric proxy comprises a sum of respective measurement parameter values from each diffraction order of a pair of complementary diffraction orders.

42. A method according to clause 39, 40 or 41, wherein the at least one asymmetric proxy comprises a difference of: a first measurement parameter value difference of first corresponding diffraction orders from each of a first sub-target type and a different second sub-target type comprised within said training targets; and a second measurement parameter value difference of second corresponding diffraction orders complementary to said first corresponding diffraction orders, from each of the first sub-target type and second sub-target type.

43. A method according to clause 42, wherein the first sub-target type and second sub-target type are each comprised within a respective target arrangement at each target location on the or each training substrate.

44. A method according to clause 42, wherein the first sub-target type and second sub-target type are each distributed over different target locations on the or each training substrate; and said asymmetric proxy is determined from two training targets of two different target locations on a training substrate.

45. A method according to any of clauses 44, wherein each said training target comprises only a single sub-target type, or a single sub-target type per measurement direction.

46. A method according to clause 38, wherein said at least one asymmetry signal comprises a phase difference between radiation scattered by a first sub-target type comprised within said training targets and radiation scattered by at least a second sub-target type comprised within said training targets, each sub-target type comprising a first grating and second grating having different pitches, and wherein the order of the gratings is reversed within the target layers between the two sub-target types.

47. A method according to clause 46, wherein said at least one asymmetry signal is determined from an average of said phase differences as obtained from: a first diffraction order of a pair of complementary diffraction orders from each sub-target type and a second diffraction order of the pair of complementary diffraction orders from each sub-target type.

48. A method according to clause 46 or 47, wherein the at least one symmetric proxy comprises a sum of respective amplitude values from each diffraction order of a pair of complementary diffraction orders.

49. A method according to any of clauses 46 to 48, wherein the at least one asymmetric proxy comprises one or both of: a difference of: a first phase difference of first corresponding diffraction orders from each of the first sub-target type and the second sub-target type and a second phase difference of second corresponding diffraction orders complementary to said first corresponding diffraction orders, from each of the first sub-target type and second sub-target type; and/or a sum of: a first amplitude difference, optionally normalized, between complementary diffraction orders of radiation scattered by the first sub-target type and a second amplitude difference, optionally normalized, between complementary diffraction orders of radiation scattered by the second sub-target type.

50. A method according to any of clauses 46 to 49, wherein said at least one target comprises at least a first cluster type comprising a first arrangement of sub-targets comprising at least a first sub-target type and a second sub-target type and a second cluster type comprising a second arrangement of sub-targets comprising at least a first sub-target type and a second sub-target type.

51. A method according to clause 50, wherein the first cluster type and second cluster type are each comprised within a respective target arrangement at each target location on the or each training substrate.

52. A method according to clause 50, wherein the first cluster type and second cluster type are each distributed over different target locations on the or each training substrate.

53. A method according to any of clauses 37 to 52, wherein said training data comprises a plurality of training asymmetry signals from each sub-target of each training target, wherein the plurality of training asymmetry signals from each sub-target relate to different regions within training images of said sub-targets from which said asymmetry signals are derived; and wherein said training step uses the plurality of training asymmetry signals relating to different regions within training images of each sub-target individually.

54. A method according to any of clauses 37 to 53, wherein said training step is preceded by a singular value decomposition step to reduce the dimensions of the training data.

55. A method according to any of clauses 37 to 54, comprising obtaining known parameter of interest values corresponding to the training data; and using said known parameter of interest values to label said training data prior to said training step, wherein the first measurement value difference and second measurement value difference is obtained from two different targets at different target locations.

56. A method according to clause 55, wherein said optimizing step comprises determining training parameter values for each said training parameter which minimize a difference between known parameter of interest values, and the product of said training parameter values and said asymmetry signals convolved with each said proxy.

57. A method according to clause 55 or 56, wherein said model comprises a first model for inferring a parameter of interest value for a first sub-target type of said training targets and a second trained model for inferring a parameter of interest value for a second sub-target type of said training targets.

58. A method according to any of clauses 37 to 54, wherein said optimizing step comprises determining training parameter values for each said training parameter which minimize a difference between: the bias magnitudes of said training targets or a multiple thereof, and the product of: said training parameter values; and the difference of: and said asymmetry signals convolved with each said proxy for a first sub-target type of said training targets and said asymmetry signals convolved with each said proxy for a second sub-target type of said training targets.

59. A processing apparatus comprising a processor, and being configured to perform the method of any preceding clause.

60. A metrology apparatus comprising the processor of clause 59.

61. A computer program comprising program instructions operable to perform the method of any of clauses 1 to 58, when run on a suitable apparatus.

62. A non-transient computer program carrier comprising the computer program of clause 61.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultraviolet (EUV) radiation (e.g., having a wavelength in the range of 5-20 nm), A well A particle beams, such A ion beams or electron beams.

The term "lens", where the context allows, may refer to any one or combination of various types of components, including refractive, reflective, magnetic, electromagnetic and electrostatic components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

**Claims**

1. A method for determining a parameter of interest relating to at least one target on a substrate, the method comprising:

obtaining metrology data comprising at least one asymmetry signal, said at least one asymmetry signal comprising a difference or imbalance in a measurement parameter from the target;
obtaining a trained model having been trained or configured to relate said at least one asymmetry signal to the parameter of interest, the trained model comprising at least one proxy for at least one nuisance component of the at least one asymmetry signal; and
inferring said parameter of interest for said at least one target from said at least one asymmetry signal using the trained model.

2. A method as claimed in claim 1, wherein said metrology data comprises after-develop metrology data, measured prior to an etch step for the layer just exposed.

3. A method as claimed in claim 1 or 2, wherein said at least one asymmetry signal comprises at least one asymmetry signal measured at an image plane or conjugate thereof of a metrology tool used to obtain said metrology data.

4. A method as claimed in any preceding claim, wherein said trained model comprises a configured training parameter for each of said at least one proxies.

5. A method as claimed in any preceding claim, wherein said at least one proxy comprises one or both of:

at least one symmetric proxy for a symmetric nuisance component of each asymmetry signal of the at least one asymmetry signal; and/or
at least one asymmetric proxy for an asymmetric nuisance component of each asymmetry signal of the at least one asymmetry signal.

6. A method as claimed in claim 5, wherein said at least one asymmetry signal comprises:
a measurement parameter asymmetry between each diffraction order of a pair of complementary diffraction orders.

7. A method as claimed in claim 6, wherein said measurement parameter is intensity or a related parameter.

8. A method as claimed in claim 6 or 7, wherein the at least one symmetric proxy comprises a sum of respective measurement parameter values from each diffraction order of a pair of complementary diffraction orders.

9. A method as claimed in claim 6, 7 or 8, wherein the at least one asymmetric proxy comprises a difference of:

a first measurement parameter value difference of first corresponding diffraction orders from each of a first sub-target type and a different second sub-target type of said at least one target; and
a second measurement parameter value difference of second corresponding diffraction orders complementary to said first corresponding diffraction orders, from each of the first sub-target type and second sub-target type.

10. A method as claimed in claim 9, wherein the first sub-target type and second sub-target type are each comprised within a respective target arrangement at each target location.

11. A method as claimed in claim 9, wherein the first sub-target type and second sub-target type are each distributed over different target locations on the substrate.

12. A method as claimed in any preceding claim, wherein each said at least one target comprises only a single sub-target type, or a single sub-target type per measurement direction.

13. A method as claimed in claim 5, wherein said at least one asymmetry signal comprises a phase difference between radiation scattered by a first sub-target type of said at least one target and radiation scattered by at least a second sub-target type of said at least one target, each sub-target type comprising a first grating and second grating having different pitches, and wherein the order of the gratings is reversed within the target layers between the two sub-target types.

14. A method as claimed in claim 13, wherein said at least one asymmetry signal is determined from an average of said phase differences as obtained from: a first diffraction order of a pair of complementary diffraction orders from each sub-target type and a second diffraction order of the pair of complementary diffraction orders from each sub-target type.

15. A method as claimed in claim 13 or 14, wherein the at least one symmetric proxy comprises a sum of respective amplitude values from each diffraction order of a pair of complementary diffraction orders.

Fig. 1

Fig. 2

Fig. 3

Fig. 4

Fig. 5

(a)

(b)

Fig. 6

(a)

(b)

Fig. 7

**EP 4 224 255 A1**

Europäisches
Patentamt

European
Patent Office

Office européen
des brevets

# EUROPEAN SEARCH REPORT

**Application Number**

EP 22 15 5715

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | "METHOD FOR DETERMING A MEASUREMENT RECIPE AND ASSOCIATED APPARATUSES", RESEARCH DISCLOSURE, KENNETH MASON PUBLICATIONS, HAMPSHIRE, UK, GB , vol. 693, no. 53 1 January 2022 (2022-01-01), XP007149915, ISSN: 0374-4353 Retrieved from the Internet: URL:ftp://ftppddoc/RDData693_EPO.zip Pdf/693053.pdf [retrieved on 2021-12-14] * paragraphs [0027], [0034] – [0038], [0043] – [0057]; figure 7 * * abstract * | 1-15 | INV. G03F7/20 |
| A | US 2019/378012 A1 (TRIPODI LORENZO [NL] ET AL) 12 December 2019 (2019-12-12) * paragraphs [0095] – [0105] * | 1-15 | |
| A | WO 2021/121906 A1 (ASML NETHERLANDS BV [NL]) 24 June 2021 (2021-06-24) * paragraphs [0251] – [0258] * | 1-15 | TECHNICAL FIELDS SEARCHED (IPC) G03F |

The present search report has been drawn up for all claims

| Place of search | Date of completion of the search | Examiner |
|---|---|---|
| Munich | 25 July 2022 | Roesch, Guillaume |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 15 5715

This annex lists the patent family members relating to the patent documents cited in the above-mentioned European search report.
The members are as contained in the European Patent Office EDP file on
The European Patent Office is in no way liable for these particulars which are merely given for the purpose of information.

25-07-2022

| Patent document cited in search report | | Publication date | Patent family member(s) | | Publication date |
|---|---|---|---|---|---|
| US 2019378012 | A1 | 12-12-2019 | CN | 112236724 A | 15-01-2021 |
| | | | TW | 202004366 A | 16-01-2020 |
| | | | US | 2019378012 A1 | 12-12-2019 |
| | | | WO | 2019233738 A1 | 12-12-2019 |
| WO 2021121906 | A1 | 24-06-2021 | TW | 202138927 A | 16-10-2021 |
| | | | WO | 2021121906 A1 | 24-06-2021 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009078708 A
- WO 2009106279 A
- US 20110027704 A
- US 20110043791 A
- US 20120242970 A
- US 2010201963 A1
- US 2011102753 A1
- WO 2021224009 A1

**Non-patent literature cited in the description**

- **MATSUNOBU et al.** Novel diffraction-based overlay metrology utilizing phase-based overlay for improved robustness. *Proc. SPIE,* 11611
- Metrology, Inspection, and Process Control for Semiconductor Manufacturing XXXV. 22 February 2021, 1161126